# EUROPEAN PATENT APPLICATION

(11) **EP 2 383 700 A1**
(43) Date of publication of application: **02.11.2011**
(21) Application number: 10250846.2
(22) Date of filing: 28.04.2010
(51) Int. Cl.: G06T 9/00, H03M 7/30, H04N 7/26, H04N 7/28

(54) **System and method for image compression**

(71) Applicant: Solomon Systech Limited, Hong Kong (HK)
(72) Inventor: Chan, Wing Chi Stephen, Kowloon, Hong Kong (HK); Choi, WaiPak Icarus, Tai Po, N.T., Hong Kong (HK)
(74) Representative: Roberts, Mark Peter

(57) **Abstract**

A method for compressing image data into a sequence of codes, the image data being represented by a plurality of input color vectors. The method includes a repetitive processing of one color vector at a time with the following steps: receiving one of the input color vectors; comparing the received input color vector with codebook words in a codebook, the codebook words being expressed as color vectors; compressing the received input color vector to generate a code based on the comparison; updating the codebook with a color vector, the color vector being generated by decoding the code; and outputting the code before receiving a next one of the input color vectors; wherein the updating may include rearranging the order of the codebook words based on the comparison.

## Description

### Technical Field

This invention pertains in general to systems and methods for compression.

### Background

Image compression for efficient image data storage and communication has an important role in digital imaging systems such as multimedia systems, high definition television (HDTV), teleconference systems, and image database management systems. Currently, image compression may be implemented based on different standards, such as the Lempel-Ziv-Welch (LZW) / Graphics-Interchange-Format (GIF) standard, the lossless Joint Photographic Experts Group (JPEG-LS) standard, the JPEG standard, and the JPEG2000 standard.

In many applications, it is crucial to reduce a size of image data before storage or transmission. For example, a mobile display driver is one application for displaying image data. Display drivers include non-memory display drivers and memory display drivers. For non-memory display drivers, image data is directly transmitted to a display panel and displayed on the panel. There is no need to store the image data internally. However, for memory display drivers, image data is stored in a display memory inside the driver, and the driver will scan through the display memory line by line for displaying the image data. A relatively large size of the display memory may undesirably raise the cost for manufacturing the display driver.

An image compression method may be used to reduce the size of a required display memory by reducing the size of the image data. If a cost increase due to additional hardware, e.g., logic gates, for implementing the image compression method is relatively small compared to a cost to be saved due to the reduced size of the display memory, the overall cost for manufacturing the display driver would be lowered by using the image compression method.

Image compression methods include lossless compression methods, for which content of a decompressed image is identical to that of an original image, and near-lossless compression methods, for which differences between the decompressed image and the original image are visually undetectable. In addition, there are lossy compression methods which aim for a high compression ratio but with visible image degradation. Since visible image degradation is not acceptable for display driver applications, lossy compression methods are not considered in the display field.

For lossless compression methods, recent efforts in international standards are represented by the JPEG-LS standard. Methods proposed for the JPEG-LS standard include image compression techniques based on, e.g., run-length coding, non-linear prediction, context-based statistics modeling, and entropy coding. A compression ratio obtained by the JPEG-LS standard typically depends on the specific content of the image data. For example, a size of the compressed image data can be larger than a size of the original image data, when the original image data is uncorrelated. To address this weakness, an option for near-lossless compression is introduced by the JPEG-JS standard. However, even with this option, the JPEG-LS standard may not guarantee a fixed compression ratio for all images.

The near-lossless compression methods are typically suitable for display drivers. This is because, on one hand, the near-lossless compression methods have the potential of achieving a fixed compression ratio and, on the other hand, an image compressed from an original image based on a near-lossless compression method is usually visually indistinguishable from the original image. The near-lossless compression methods generally involve quantization applied to image data. In quantization, a high-precision image description is converted to a low-precision image description, typically through a many-to-one mapping. Quantization methods include scalar quantization (SQ) methods and vector quantization (VQ) methods. In scalar quantization, each input image data stream is processed separately to produce an output. In vector quantization, more than one input image data streams are grouped together, called vectors, and processed to produce an output.

Typically, vector quantization is a block-based approach that maps each image block of pixels into a corresponding index based on a codebook. Transmitting the index would transmit fewer bits than transmitting the image block. The block-based approach may use transform techniques such as Discrete Cosine Transform (DCT) and Discrete Wavelet Transform (DWT).

However, block-based approaches, such as the JPEG standard and the JPEG2000 standard, need extra numbers of line memories for image data compression process, and a large number of logical gates with high complexity for hardware implementation. The cost increase due to die size and power consumption of the hardware implementation is usually higher than the cost saved due to the reduced size of the display memory.

### SUMMARY

The features of the invention are defined in the claims. However, where a claim contains multiple features, it must be understood that any one of those features may be applied independently of the others. Accordingly, no assumption is to be drawn that the claims define strict combinations of features that must be grouped together for technical reasons.

Consistent with the invention, there is provided a method for compressing image data into a sequence of codes, the image data being represented by a plurality of input color vectors, the method comprising a repetitive processing of one color vector at a time with the following steps: receiving one of the input color vectors; comparing the received input color vector with codebook words in a codebook, the codebook words being expressed as color vectors; compressing the received input color vector to generate a code based on the comparison; updating the codebook with a color vector, the color vector being generated by decoding the code; and outputting the code before receiving a next one of the input color vectors; wherein the updating may include rearranging the order of the codebook words based on the comparison.

Optionally, the receiving further comprises converting the received input color vector into a predetermined color format before the comparison.

Optionally, the predetermined color format includes a luminance signal and first and second color difference signals, the first and second color difference signals having a lower resolution than the luminance signal.

Optionally, the compressing comprises: identifying a codebook word in the codebook, the identified codebook word and the received input color vector having a smallest absolute vector difference; determining, within a tolerance, a match between the received input color vector and the identified codebook word based on the comparison; obtaining a codebook pointer indicating a location of the indentified codebook word in the codebook; and encoding the codebook pointer to generate the code; and the updating comprises: moving the identified codebook word into the first entry of the codebook; and shifting any one of the codebook words that is in an entry before the entry where the identified codebook is located into a next entry of the codebook.

Optionally, the compressing comprises: calculating an absolute vector difference between the received input color vector and the codebook words individually in the first few entries, or at least the codebook word in the first entry, of the codebook; determining a smallest one of the calculated differences is within a describable range by a code based on the comparison; and encoding the smallest difference and a codebook pointer to the codebook word having the smallest difference to generate the code; and the updating comprises: generating a color vector to approximate the received input color vector based on the code; shifting all codebook words in the codebook each into a next entry of the codebook; and storing the generated color vector as a codebook word in the first entry of the codebook.

Optionally, the compressing comprises encoding the received input color vector directly to generate the code based on the comparison; and the updating comprises: generating a color vector to approximate the received input color vector based on the code; shifting all codebook words in the codebook each into a next entry of the codebook; and storing the generated color vector as a codebook word in the first entry of the codebook.

Optionally, the code comprises a prefix code.

Optionally, pre-defined quantization levels are encoded in the prefix code.

Optionally, the code has a variable length.

Optionally, the code lengths are fixed at a small number of lengths and code lengths are multiples of a minimum length.

Optionally, the method further comprises receiving a quantization level from a rate control unit, wherein the code is generated based on the quantization level.

Optionally, the quantization levels are pre-defined at a vector level, tolerances for vector components being pre-defined differently at each quantization level.

Optionally, the method further comprises storing the code in a memory device to reduce a size of the memory device.

Optionally, the method further comprises transmitting the code through a communication channel to reduce a bandwidth of the communication channel.

Also consistent with the invention, there is provided a method for decompressing a sequence of codes into image data, the sequence of codes each representing a codebook pointer, a difference between color vectors, or a color vector, the method comprising a repetitive processing of one code at a time with the following steps: receiving one of the codes; determining whether the received code represents a codebook pointer, a difference between color vectors, or a color vector, based on header information in the received code; decoding the received code to generate a color vector based on the determination and on codebook words in a codebook; updating the codebook based on the generated color vector; and outputting the generated color vector before receiving a next one of the codes; wherein the updating may include rearranging the order of the codebook words based on the determination.

Optionally, the decoding comprises: obtaining, if it is determined that the received code represents a codebook pointer, a codebook word in the codebook indicated by the codebook pointer; wherein the obtained codebook word is the generated color vector.

Optionally, the decoding comprises: generating, if it is determined that the received code represents a difference between color vectors, the color vector based on the difference and a codebook word in the codebook.

Optionally, the decoding comprises: generating, if it is determined that the received code represents a color vector, the color vector directly from the received code.

Optionally, the updating comprises: shifting at least one of the codebook words in the codebook into a next entry of the codebook; and storing the generated color vector as a codebook word in the first entry of the codebook.

Further, and consistent with the invention, there is provided an apparatus for compressing image data into a sequence of codes, the image data being represented by a plurality of input color vectors, the apparatus comprising: a codebook configured to store a plurality of codebook words expressed as color vectors; an encoder configured to receive one of the input color vectors, compare the received input color vector with the codebook words, and compress the received input color vector to generate a code based on the comparison; and a codebook controller configured to update the codebook based on the code; wherein the encoder coordinates the codebook and the codebook controller such that the input color vectors are processed one at a time.

Optionally, the encoder is further configured to convert the received input color vector into a predetermined color format.

Optionally, the encoder is further configured to: identify a codebook word in the codebook, the identified codebook word and the received input color vector having a smallest absolute vector difference; determine, within a tolerance, a match between the received input color vector and the identified codebook word based on the comparison; obtain a codebook pointer indicating a location of the identified codebook word in the codebook; and encode the codebook pointer to generate the code; and the codebook controller is configured to: move the identified codebook word into the first entry of the codebook; and shift any one of the codebook words that is in an entry before the entry where the identified codebook is located into a next entry of the codebook.

Optionally, the encoder is further configured to: calculate an absolute vector difference between the received input color vector and the codebook word in the first entry of the codebook; determine the difference is within a descriable range by a code; and encode the difference to generate the code; and the codebook controller is configured to: generate a color vector to approximate the received input color vector based on the code; shift all codebook words in the codebook each into a next entry of the codebook; and store the generated color vector as a codebook word into the first entry of the codebook.

Optionally, the encoder is configured to encode the received input color vector directly to generate the code; and the codebook controller is configured to: generate a color vector to approximate the received input color vector based on the code; shift all codebook words in the codebook each into a next entry of the codebook; and store the generated color vector as a codebook word into the first entry of the codebook.

Optionally, the code comprises a prefix code.

Optionally, the code has a variable length.

Further, and consistent with the invention, there is provided an apparatus for decompressing a sequence of codes into image data, the sequence of codes each representing a codebook pointer, a difference between color vectors, or a color vector, the apparatus comprising: a codebook configured to store a plurality of codebook words expressed as color vectors; a decoder configured to receive one of the codes, determine whether the received code represents a codebook pointer, a difference between color vectors, or a color vector, and decode the received code to generate a color vector based on the determination and on the codebook words in the codebook; and a codebook controller configured to update the codebook based on the generated color vector; wherein the decoder coordinates the codebook and the codebook controller such that the sequence of codes are processed one at a time.

Optionally, the decoder is further configured to: obtain, if it is determined that the received code represents a codebook pointer, a codebook word in the codebook indicated by the codebook pointer; wherein the obtained codebook word is the generated color vector.

Optionally, the decoder is configured to: generate, if it is determined that the received code represents a difference between color vectors, the color vector based on the difference and a codebook word in the first entry of the codebook.

Optionally, the decoder is configured to: generate, if it is determined that the received code represents a color vector, the color vector directly from the received code.

Optionally, the codebook controller is configured to: shift at least one of the codebook words in the codebook into a next entry of the codebook; and store the generated color vector as a codebook word in the first entry of the codebook.

Also consistent with the invention, there is provided a computer-readable medium including instructions, executable by a processor in an image processing system, for performing a method for compressing image data into a sequence of codes, the image data being represented by a plurality of input color vectors, the method comprising: receiving one of the input color vectors; comparing the received input color vector with codebook words in a codebook, the codebook words being expressed as color vectors; compressing the received input color vector to generate a code based on the comparison; and updating the codebook with a color vector, the color vector being generated by decoding the code; and outputting the code as compressed image data; wherein the updating may include rearranging the order of the codebook words based on the comparison.

Also consistent with the invention, there is provided a computer-readable medium including instructions, executable by a processor in an image processing system, for performing a method for decompressing a sequence of codes into image data, the sequence of codes each representing a codebook pointer, a difference between color vectors, or a color vector, the method comprising: receiving one of the codes; determining whether the received code represents a codebook pointer, a difference between color vectors, or a color vector, based on header information in the received code; decoding the received code to generate a color vector based on the determination and on codebook words in a codebook; updating the codebook based on the generated color vector; and outputting the generated color vector as decompressed image data; wherein the updating may include rearranging the order of the codebook words based on the determination.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this specification, illustrate embodiments of the invention and, together with the description, serve to explain the principles of the invention.

Figure 1 is a block diagram of an image data coding/decoding (compression/decompression) apparatus, according to an exemplary embodiment.

Figure 2 is a flowchart for a CODEC to encode original image data, according to an exemplary embodiment.

Figure 3 is a flowchart for a CODEC to decode compressed image data, according to an exemplary embodiment.

Figure 4 illustrates a method for updating a codebook, according to an exemplary embodiment.

### DESCRIPTION OF THE EMBODIMENTS

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of systems and methods consistent with aspects related to the invention as recited in the appended claims.

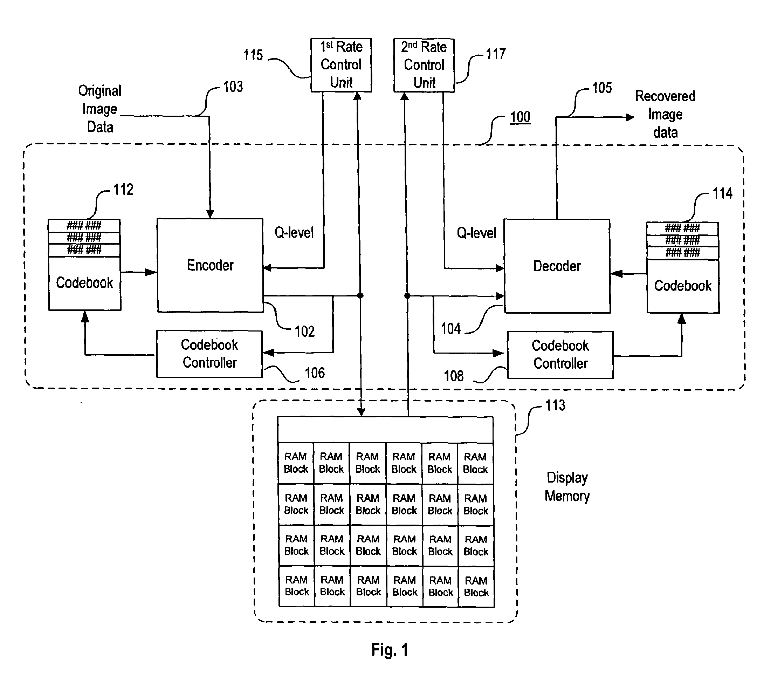

Figure 1 illustrates a block diagram of an image data COding/DECoding (COmpression/DECompression) apparatus 100, referred to herein as the CODEC 100, according to an exemplary embodiment. The CODEC 100 may include an encoder 102, a decoder 104, first and second codebook controllers 106 and 108, and first and second codebooks 112 and 114.

In exemplary embodiments, the CODEC 100 may use a vector quantization method to achieve a small codebook size with a high match rate. The CODEC 100 synchronously updates the codebooks 112 and 114 during encoding and decoding, which will be described in more detail below.

In addition, the CODEC 100 receives a current quantization level (Q-level) from each of first and second rate control units 115, 117, shown in Fig. 1. The first and second rate control units 115 and 117 are the same, and each of them calculates the current Q-level based on a historical compression ratio. On the other hand, the CODEC 100 may work with any type of rate control unit.

In exemplary embodiments, the CODEC 100 receives original image data, which may be represented by a plurality of input color vectors, at an input terminal 103. The CODEC 100 compresses the plurality of input color vectors to generate a plurality of codes, as such as a sequence of prefix codes, as encoded image data, and stores the encoded image data in a display memory 113, shown in Fig. 1. The CODEC 100 further fetches the encoded image data, i.e., the prefix codes, from the display memory 113, and decodes the encoded image data to generate recovered image data, represented by a plurality of output color vectors, at an output terminal 105.

In exemplary embodiments, each of the plurality of input and output color vectors may be defined in a color format according to a color standard, such as a (Y, U, V) color format, an (R, G, B) color format, an (H, S, V) color format, etc. The CODEC 100 may convert the plurality of input color vectors in an original color format into color vectors in a predetermined color format. The CODEC 100 may then encode the color vectors in the predetermined color format to generate the encoded image data.

The CODEC 100 may also fetch the encoded image data from the display memory 113, and decode the encoded image data into color vectors in the predetermined color format. The CODEC 100 further converts the decoded color vectors in the predetermined color format to color vectors in the original color format. For example, the predetermined color format may be a (Cr, L, Cb) color format, where L is a luminance signal, and Cr and Cb are color difference signals. Also for example, the color difference signals Cr and Cb may have a lower resolution compared to the luminance signal L.

In one exemplary embodiment, the original image data includes red, green, and blue data streams, which may be represented by the plurality of input color vectors in the (R, G, B) color format. The CODEC 100 may convert the plurality of input color vectors each into a color vector in the (Cr, L, Cb) color format for encoding and decoding. As a result, the CODEC 100 alone is enough for encoding and decoding, instead of three separate coding/decoding units, one for each of the red, green, blue data streams.

Referring to Fig. 1, the encoder 102 receives an i^{th} one of the plurality of input color vectors in the (R, G, B) color format, and converts the i^{th} color vector into a color vector in the predetermined color format such as the (Cr, L, Cb) color format. The encoder 102 then encodes the converted color vector to generate a code, e.g., a prefix code, as the encoded image data corresponding to the i^{th} color vector, based on the codebook 112 and the current Q-level received from the first rate control unit 115.

In one exemplary embodiment, the encoder 102 may generate the prefix code based on one of first, second, and third types of data, corresponding to a codebook pointer, relative data, and absolute data, respectively. A codebook pointer indicates a location in the codebook 112 or 114, and is typically has a small number of bits. Relative data represents a difference of values between two color vectors, i.e., an absolute vector difference, and typically has a larger number of bits than the codebook pointer. Absolute data represents a value of a color vector, and typically has a larger number of bits than relative data. Therefore, it would be beneficial to generate the prefix code using a codebook pointer than using either relative data or absolute data. Similarly, it would be beneficial to generate the prefix code using relative data than using absolute data.

The encoder 102 further outputs the prefix code to the first codebook controller 106 and the display memory 113. The first codebook controller 106 updates the codebook 112 based on the prefix code, which will be described in more detail below.

The decoder 104 may fetch the prefix code, i.e., the encoded image data corresponding to the i^{th} color vector, from the display memory 113. The decoder 104 decodes the fetched prefix code according to the prefix code protocol, and generates a color vector in the (Cr, L, Cb) color format, based on the codebook 114 and the current Q-level received from the second rate control unit 117. The decoder 104 further converts the generated color vector in the (Cr, L, Cb) color format to a color vector in the (R, G, B) color format, i.e., an i^{th} one of the plurality of output color vectors. In addition, the second codebook controller 108 updates the codebook 114, which will be described in more detail below.

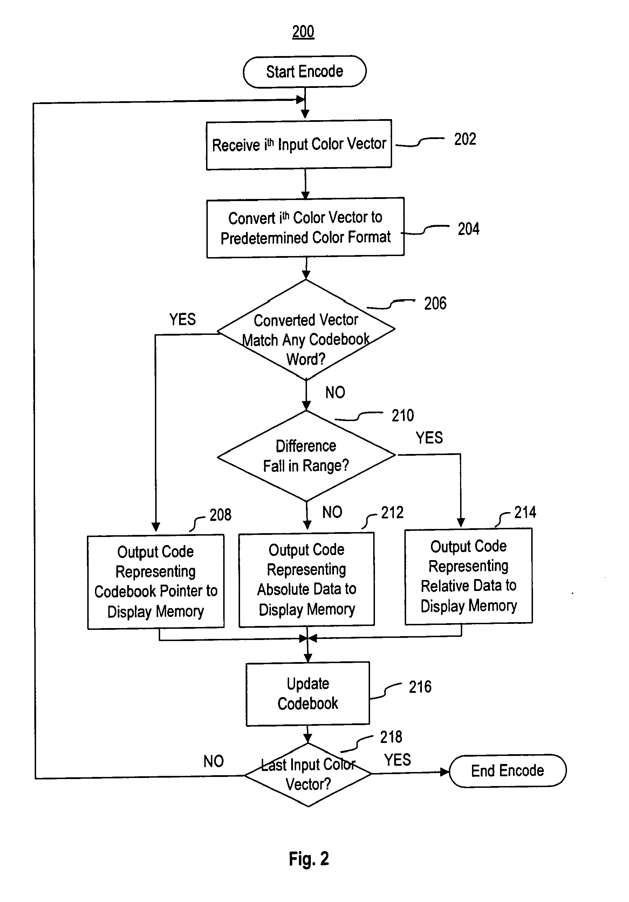

Fig. 2 illustrates a flowchart 200 for the CODEC 100 (Fig. 1) to encode the plurality of input color vectors representing the original image data, according to an exemplary embodiment. For convenience of illustration, interactions between the encoder 102 and the first rate control unit 115 are not illustrated in Fig. 2.

Referring to Figs. 1 and 2, the encoder 102 receives the i^{th} one of the plurality of input color vectors in the (R, G, B) color format (step 202), and converts the i^{th} input color vector into a color vector in the predetermined color format such as the (Cr, L, Cb) color format (step 204). The encoder 102 then compares the converted color vector with codebook words stored in the codebook 112 to determine, within a tolerance, if there is a match between the converted color vector and any one of the codebook words (step 206). For example, if a difference between the converted color vector and any one of the codebook words is less than a predetermined threshold, the encoder 102 may determine there is a match. Also for example, if it is determined that multiple codebook words satisfy the match, the encoder 102 may select one of the multiple codebook words, the selected codebook word and the converted color vector having a smallest absolute vector difference.

If the encoder 102 determines there is a match between the converted color vector and one of the codebook words, the encoder 102 outputs to the display memory 113 the prefix code representing a codebook pointer that indicates a location of the one of the codebook words in the codebook 112 (step 208).

If the encoder 102 does not determine a match, the encoder 102 calculates a difference between the value of the converted vector and the codebook word in the first entry of the codebook 112. The encoder 102 further checks whether the difference falls in a range that can be described using relative data (step 210).

If the encoder 102 determines the difference does not fall in the range, the encoder 102 outputs the prefix code representing the value of the converted vector, i.e., the absolute data (step 212). If the encoder 102 determines the difference falls in the range, the encoder 102 outputs the prefix code representing the difference, i.e., relative data (step 214). The first codebook controller 106 then updates the codebook 112 (step 216), which will be described in more detail below. The encoder 102 further determines whether the i^{th} input color vector is a last one of the plurality of input vectors (step 218). If not, steps 202-218 are repeated.

In accordance with an alternative aspect of this exemplary embodiment, if the encoder 102 does not determine a match, the encoder 102 calculates a difference between the value of the converted vector and the codebook words individually in the first several (e.g. 1 to 4) entries of the codebook 112. The encoder 102 further checks whether the smallest difference among these calculated differences falls in a range that can be described using relative data (step 210).

Further in accordance with the alternative aspect of this exemplary embodiment, if the encoder 102 determines the smallest difference among the calculated differences does not fall in the range, the encoder 102 outputs the prefix code representing the value of the converted vector, i.e., the absolute data (step 212). If the encoder 102 determines the smallest difference falls in the range, the encoder 102 outputs the prefix code representing the difference and a codebook pointer to the codebook word having the smallest difference, i.e., relative data (step 214).

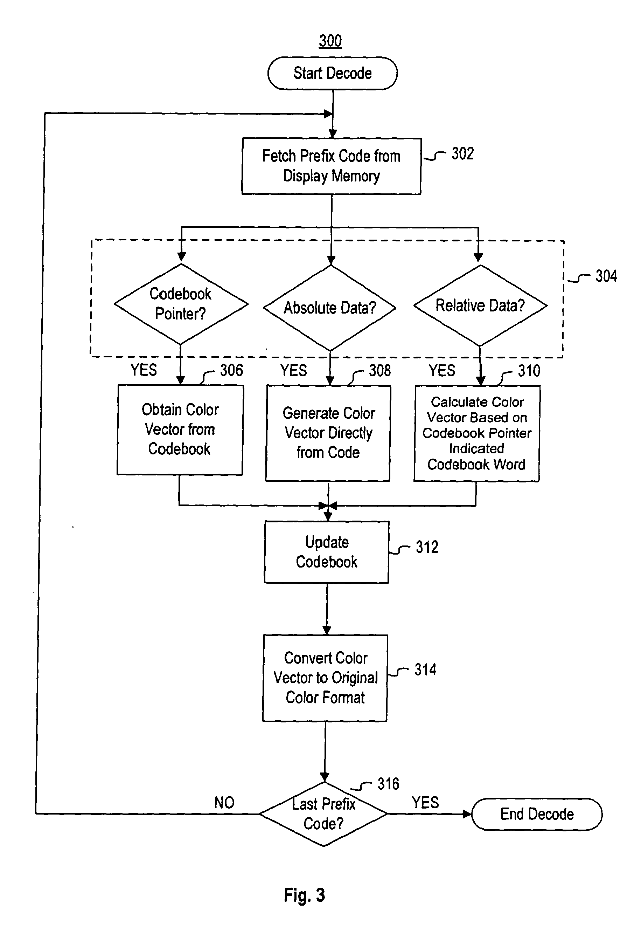

Fig. 3 is a flowchart 300 of a method for the CODEC 100 (Fig. 1) to decode the encoded image data, according to an exemplary embodiment. For convenience of illustration, interactions between the decoder 104 and the second rate control unit 117 are not illustrated in Fig. 3.

Referring to Figs. 1 and 3, the decoder 104 fetches a prefix code, such as the prefix code corresponding to the i^{th} input color vector, from the display memory 113 (step 302). The decoder 104 determines whether the fetched prefix code represents a codebook pointer, a difference between color vectors (relative data), or a color vector (absolute data), based on header information in the fetched prefix code (step 304).

If the fetched prefix code represents a codebook pointer, the decoder 104 reads one of the codebook words in the codebook 114 indicated by the codebook pointer (step 306). Due to synchronization between the codebook 112 and the codebook 114, the read codebook word is the decoded color vector corresponding to the i^{th} input color vector.

If the fetched prefix code (step 304) represents a difference between color vectors, the decoder 104 calculates a color vector based on the difference and the codebook pointer indicated codebook word in the codebook 114 (step 308). The calculated color vector is the decoded color vector corresponding to the i^{th} input color vector.

If the fetched prefix code (step 304) represents a color vector, the decoder 104 decodes the prefix code directly to generate the decoded color vector corresponding to the i^{th} input color vector (step 310). In each situation, the decoded color vector is in the predetermined color format such as the (Cr, L, Cb) color format.

The second codebook controller 108 then updates the codebook 114 (step 312). The decoder 104 further converts the decoded color vector from the predetermined color format to the original color format, i.e., the (R,G,B) color format, to generate the i^{th} one of the output color vectors (step 314). The decoder 104 also determines whether the prefix code correspond to the i^{th} input color vector is a last one of the prefix codes fetched from the display memory 113 (step 316). If not, steps 302-316 are repeated.

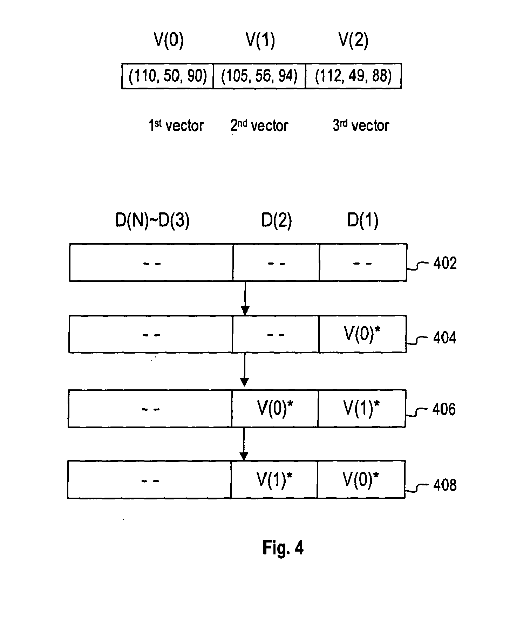

Figure 4 illustrates a method for updating the codebook 112 or 114 in the CODEC 100 (Fig. 1), according to an exemplary embodiment. Referring to Figs. 1 and 4, the codebooks 112 and 114 are synchronously updated during encoding and decoding.

On the encoder side, the codebook 112 is set to be empty at an initial stage (step 402). For example, each of entries D(1) to D(N) in the codebook 112 may be set to have a codebook word (0, 0, 0). When the encoder 102 receives the first one of the plurality of input color vectors representing the original image data, the encoder 102 converts the first color vector to a color vector, V(0), in the predetermined color format such as the (Cr, L, Cb) color format. For example, the color vector V(0) may have a value (110, 50, 90).

The encoder 102 compares the vector V(0) with codebook words in the entries D(1) to D(N) of the codebook 112. In the illustrated embodiment, each of the entries D(1) to D(N) has the codebook word (0, 0, 0) at the initial stage. Therefore there may not be a match between the color vector V(0) and any of the codebook words. The encoder 120 further calculates a difference between the value of the color vector V(0) and the codebook word in the first entry D(1). The encoder 102 determines that the difference is relatively large and, therefore, outputs a first prefix code representing the the color vector V(0), i.e., absolute data, to the display memory 113 and the codebook controller 106.

The codebook controller 106 receives the first prefix code and generates a recovered color vector V(0)* corresponding to the color vector V(0). In reality, a value of the color vector V(0)* is typically close to the value of the color vector V(0), but may not be exactly equal to the value of the color vector V(0). The codebook controller 106 further shifts the recovered color vector V(0)* as a codebook word into the first entry D(1) of the codebook 112 (step 404).

When the encoder 102 receives the second one of the plurality of input color vectors, the encoder 102 converts the second input color vector to a color vector, V(1), in the predetermined color format such as the (Cr, L, Cb) color format. For example, the color vector V(1) may have a value (105, 56, 94).

The encoder 102 further compares the color vector V(1) with the codebook words in the entries D(1) to D(N) of the codebook 112. Currently, only the first entry D(1) has a non-zero codebook word, i.e., the color vector V(0)*. The encoder 102 compares the color vector V(1) with the color vector V(0)*. In the illustrated embodiment, the encoder 102 determines there is no match between the color vector V(1) and the color vector V(0)*.

The encoder 102 further calculates a difference between the value of the color vector V(1) and the value of the color vector V(0)*, and determines that the calculated difference may be described using relative data. Therefore the encoder 102 outputs a second prefix code representing the calculated difference and the codebook pointer to V(0)* to the display memory 113 and the codebook controller 106.

The codebook controller 106 generates a recovered color vector V(1)* corresponding to the color vector V(1), based on the second prefix code and the codebook word in the first entry D(1) of the codebook 112, i.e., the color vector V(0)*. Again, in reality, a value of the color vector V(1)* is typically close to, but may not be exactly equal to, the value of the color vector V(1). The codebook controller 106 further shifts the color vector V(0)* from the first entry D(1) to the second entry D(2), and shifts the recovered color vector V(1)* as a codebook word into the first entry D(1) (step 406).

When the encoder 102 receives the third one of the plurality of input color vectors, the encoder 102 converts the third color vector to a color vector, V(2), in the predetermined color format such as the (Cr, L, Cb) color format. For example, the color vector V(2) may have a value (112, 49, 88).

The encoder 102 further compares the color vector V(2) with the codebook words in the entries D(1) to D(N) of the codebook 112. Currently, only the first and second entries D(1) and D(2) each have a non-zero codebook word, i.e., the color vectors V(0)* and V(1)*. The encoder 102 compares the color vector V(2) with the color vectors V(0)* and V(1)*. In the illustrated embodiment, the encoder 102 determines there is a match between the color vector V(2) and the color vector V(0)*. Therefore the encoder 102 outputs a third prefix code representing a codebook pointer, which indicates a current location of the color vector V(0)* in the codebook 112, to the display memory 113 and the codebook controller 106.

The codebook controller 106 moves the matched codebook word, i.e., the color vector V(0)*, into the first entry D(1) of the codebook 112. In addition, the codebook controller 106 performs a shift of the codebook word in any one of the entries D(1) to D(N) that is before the entry where the matched codeword is located. For example, the codebook controller 106 moves the color vector V(0)* in the second entry D(2) into the first entry D(1), and shifts the color vector V(1)* from the first entry D(1) into the next entry D(2) (step 408).

Similar to the description above in connection with the codebook 112 based on the first, second, and third ones of the plurality of input color vectors, the codebook controller 106 may update the codebook 112 based on following ones of the plurality of input color vectors.

Referring again to Fig. 4, on the decoder side, the codebook 114 is also set to be empty at the initial stage (step 402). For example, each of entries D(1) to D(N) in the codebook 114 may be set to have a codebook word (0, 0, 0). The decoder 104 fetches the first prefix code from the display memory 113, and based on header information in the first prefix code, the decoder 104 may determine the first prefix code represents a color vector, i.e., absolute data. Therefore the decoder 104 decodes the first prefix code directly to generate the color vector V(0)* in the predetermined color format such as the (Cr, L, Cb) color format. The codebook controller 108 moves the color vector V(0)* as a codebook word into the first entry D(1) of the codebook 114 (step 404).

The decoder 104 fetches the second prefix code from the display memory 113, and based on header information in the second prefix code, the decoder 104 may determine the second prefix code represents a difference between color vectors, i.e., relative data. Therefore the decoder 104 decodes the second prefix code to obtain the color vector V(1)* in the (Cr, L, Cb) color format, based on the difference and the codebook word in the first entry D(1) of the codebook 114, i.e., the color vector V(0)*. The codebook controller 108 further moves the obtained color vector V(1)* as a codebook word into the first entry D(1), and shifts the color vector V(0)* into the second entry D(2) (step 406).

The decoder 104 fetches the third prefix code from the display memory 113, and based on header information in the third prefix code, the decoder 104 may determine the third prefix code represents a codebook pointer. Therefore the decoder 104 obtains the codebook word indicated by the codebook pointer in the codebook 114, which is the color vector V(0)*.

The codebook controller 108 further shifts the codebook word indicated by the codebook pointer, i.e., the color vector V(0)*, into the first entry D(1), and performs a shift of the codebook word in any one of the entries D(1) to D(N) that is before the entry indicated by the codebook pointer. For example, the decoder 104 shifts the codebook word V(0)* to the first entry D(1), and shifts the codebook word V(1)* into the next entry D(2) (step 408).

Similar to the description above in connection with updating the codebook 114 based on the first, second, and third prefix codes, the codebook controller 108 may update the codebook 114 based on following ones of the prefix codes fetched from the display memory 113. In this way, the codebooks 112 and 114 are synchronously updated.

In exemplary embodiments, when more and more codebook words are generated and moved into the codebook 112 or 114, the codebook 112 or 114 may be filled up ultimately. When the codebook 112 or 114 is filled up with codebook words, a new codebook word may be moved into the codebook 112 or 114 if the codebook in the last entry D(N) is shifted out of the codebook 112 or 114. The codebook in the last entry D(N) of the codebook 112 or 114 is typically in least frequent use. In other words, when the new codebook word is moved into the codebook 112 or 114, the codebook word in least frequent use is shifted out of the codebook 112 or 114. In one exemplary embodiment, a size of the codebook 112 or 114 may be determined experimentally.

In exemplary embodiments, the CODEC 100 may reduce the size of the display memory by at least 50% with a data compression ratio being equal to two or higher, while maintaining image quality with substantially no perceivable degradation. The CODEC 100 may also reduce the bandwidth of a communication channel through which image data compressed by the CODEC 100 is transmitted. In addition, the CODEC 100 may be designed for efficient hardware implementation such that hardware overhead for the CODEC 100 may be less than 30 thousand logical gates. Furthermore, the CODEC 100 only needs relatively low power consumption to perform encoding or decoding. Typically, the power saved by using a display memory with a 50% reduced size is more than the additional power consumption needed by the CODEC 100.

In another exemplary embodiment, to further reduce hardware complexity, absolute vector difference may be approximated by a sum of the absolute differences of the vector components such as Cr, L, Cb. In another exemplary embodiment, to further reduce hardware complexity, the variable lengths of the prefix codes may be predetermined to be fixed at a small number of lengths and such lengths may be multiples of a minimum length.

In another exemplary embodiment, to increase coding efficiency, quantization levels (Q-levels) may be pre-defined at the vector level, i.e., the tolerances for the vector components are pre-defined differently at each Q-level. For example, one Q-level can be defined with tolerances of +/-1 for all Cr/Cb and L components, while another Q-level can be defined with tolerances of +/-3 for Cr/Cb and +/- 2 for L. In another exemplary embodiment, the Q-levels may be encoded in the prefix code.

In another exemplary embodiment, for a display memory for providing Quarter Video Graphics Array (QVGA) image resolution, the size of the display memory using prior art methods and apparatus could be over one million bits. Net hardware and cost reductions may be achieved by employing embodiments consistent with the present invention in a device using the display memory. Net hardware and cost reductions become more favorable for higher image resolutions such as VGA and SVGA.

In exemplary embodiments, the CODEC 100 may perform random line access to the display memory, and allow image data updated line by line. In addition, the CODEC 100 may provide good quality for both continuous-tone images, e.g., photographs, and discrete-tone images, e.g., computer generated user interlace graphics.

In exemplary embodiments, there is also provided a computer-readable medium including instructions, executable by a processor in an image processing system, for performing the above described method for compressing/decompressing image data.

Other embodiments will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with a true scope and spirit of the invention being indicated by the following claims.

It will be appreciated that the present invention is not limited to the exact construction that has been described above and illustrated in the accompanying drawings, and that various modifications and changes can be made without departing from the scope thereof. It is intended that the scope of the invention only be limited by the appended claims.

## Claims

1. A method for compressing image data into a sequence of codes, the image data being represented by a plurality of input color vectors, the method comprising a repetitive processing of one color vector at a time with the following steps:
receiving one of the input color vectors;
comparing the received input color vector with codebook words in a codebook, the codebook words being expressed as color vectors;
compressing the received input color vector to generate a code based on the comparison;
updating the codebook with a color vector, the color vector being generated by decoding the code; and
outputting the code before receiving a next one of the input color vectors;
wherein the updating may include rearranging the order of the codebook words based on the comparison.

2. The method of claim 1, wherein the receiving further comprises converting the received input color vector into a predetermined color format before the comparison, optionally wherein the predetermined color format includes a luminance signal and first and second color difference signals, the first and second color difference signals having a lower resolution than the luminance signal.

3. The method of claim 1 or 2, wherein
the compressing comprises:
identifying a codebook word in the codebook, the identified codebook word and the received input color vector having a smallest absolute vector difference;
determining, within a tolerance, a match between the received input color vector and the identified codebook word based on the comparison;
obtaining a codebook pointer indicating a location of the indentified codebook word in the codebook; and
encoding the codebook pointer to generate the code; and
the updating comprises:
moving the identified codebook word into the first entry of the codebook;and
shifting any one of the codebook words that is in an entry before the entry where the identified codebook is located into a next entry of the codebook.

4. The method of any one of claims 1 to 3, wherein
the compressing comprises:
calculating an absolute vector difference between the received input color vector and the codebook words individually in the first few entries, or at least the codebook word in the first entry, of the codebook;
determining a smallest one of the calculated differences is within a describable range by a code based on the comparison; and
encoding the smallest difference and a codebook pointer to the codebook word having the smallest difference to generate the code; and
the updating comprises:
generating a color vector to approximate the received input color vector based on the code;
shifting all codebook words in the codebook each into a next entry of the codebook; and
storing the generated color vector as a codebook word in the first entry of the codebook.

5. The method of any one of claims 1 to 4, wherein
the compressing comprises encoding the received input color vector directly to generate the code based on the comparison; and
the updating comprises:
generating a color vector to approximate the received input color vector based on the code;
shifting all codebook words in the codebook each into a next entry of the codebook; and
storing the generated color vector as a codebook word in the first entry of the codebook.

6. The method of any one of the preceding claims, wherein one or both of (a) and (b) apply:
(a) the code comprises a prefix code and optionally pre-defined quantization levels are encoded in the prefix code;
(b) the code has a variable length and optionally the code lengths are fixed at a small number of lengths and code lengths are multiples of a minimum length.

7. The method of any one of claims 1 to 6, further comprising one, two or all three of (a), (b) and (c):
(a) receiving a quantization level from a rate control unit, wherein the code is generated based on the quantization level, optionally wherein the quantization levels are pre-defined at a vector level, tolerances for vector components being pre-defined differently at each quantization level;
(b) storing the code in a memory device to reduce a size of the memory device;
(c) transmitting the code through a communication channel to reduce a bandwidth of the communication channel.

8. A method for decompressing a sequence of codes into image data, the sequence of codes each representing a codebook pointer, a difference between color vectors, or a color vector, the method comprising a repetitive processing of one code at a time with the following steps:
receiving one of the codes;
determining whether the received code represents a codebook pointer, a difference between color vectors, or a color vector, based on header information in the received code;
decoding the received code to generate a color vector based on the determination and on codebook words in a codebook;
updating the codebook based on the generated color vector; and
outputting the generated color vector before receiving a next one of the codes;
wherein the updating may include rearranging the order of the codebook words based on the determination.

9. The method of claim 8, wherein the decoding comprises one, two or all three of (a) (b) and (c):
(a) obtaining, if it is determined that the received code represents a codebook pointer, a codebook word in the codebook indicated by the codebook pointer; wherein the obtained codebook word is the generated color vector;
(b) generating, if it is determined that the received code represents a difference between color vectors, the color vector based on the difference and a codebook word in the codebook;
(c) generating, if it is determined that the received code represents a color vector, the color vector directly from the received code.

10. The method of claim 8 or 9, wherein the updating comprises:
shifting at least one of the codebook words in the codebook into a next entry of the codebook; and
storing the generated color vector as a codebook word in the first entry of the codebook.

11. An apparatus for compressing image data into a sequence of codes, the image data being represented by a plurality of input color vectors, the apparatus comprising:
a codebook configured to store a plurality of codebook words expressed as color vectors;
an encoder configured to receive one of the input color vectors, compare the received input color vector with the codebook words, and compress the received input color vector to generate a code based on the comparison; and
a codebook controller configured to update the codebook based on the code;
wherein the encoder coordinates the codebook and the codebook controller such that the input color vectors are processed one at a time.

12. The apparatus of claim 11, wherein the encoder is configured to perform the receiving and compressing steps of any one of claims 2 to 7 and/or the codebook controller is configured to perform the updating steps of any one of claims 2 to 7.

13. An apparatus for decompressing a sequence of codes into image data, the sequence of codes each representing a codebook pointer, a difference between color vectors, or a color vector, the apparatus comprising:
a codebook configured to store a plurality of codebook words expressed as color vectors;
a decoder configured to receive one of the codes, determine whether the received code represents a codebook pointer, a difference between color vectors, or a color vector, and decode the received code to generate a color vector based on the determination and on the codebook words in the codebook; and
a codebook controller configured to update the codebook based on the generated color vector;
wherein the decoder coordinates the codebook and the codebook controller such that the sequence of codes are processed one at a time.

14. The apparatus of claim 13, wherein the decoder is configured to perform any of the decoding steps of claim 9 and/or said codebook controller is configured to perform the updating step of claim 10.

15. A computer-readable medium including instructions, executable by a processor in an image processing system, for performing a method for compressing image data into a sequence of codes according to any one of claims 1 to 7 or a computer-readable medium including instructions, executable by a processor in an image processing system, for performing a method for decompressing a sequence of codes into image data according to any one of claims 8 to 10.
